# EUROPEAN PATENT APPLICATION

(11) **EP 1 130 407 A2**
(43) Date of publication of application: **05.09.2001**
(21) Application number: 01104884.0
(22) Date of filing: 28.02.2001
(51) Int. Cl.: G01R 31/02

(54) **High frequency component, communication apparatus, and method for measuring characteristics of high frequency components**

(30) Priority: 29.02.2000 JP 2000053313
(71) Applicant: Murata Manufacturing Co., Ltd., Nagaokakyo-shi Kyoto-fu 617-8555 (JP)
(72) Inventor: Yoshida, Norio, Nagaokakyo-shi, Kyoto-fu 617-8555 (JP); Watanabe, Takahiro, Nagaokakyo-shi, Kyoto-fu 617-8555 (JP); Ito, Tomonori, Nagaokakyo-shi, Kyoto-fu 617-8555 (JP)
(74) Representative: Schoppe, Fritz, Dipl.-Ing.

(57) **Abstract**

A high frequency component is disclosed in which the characteristics of a high frequency circuit that cannot be measured only by an outwardly led-out terminal electrode can be easily measured at the final-product stage. In the high frequency component, on a substrate (1) there is formed an electrode pattern including a signal measuring electrode pad (3). Additionally, chip components are mounted on the substrate (1). A metal cover (2) has a hole (4) formed near the signal measuring electrode pad (3). Through the hole (4), a probe of a measuring apparatus is inserted from the outside to abut with the electrode pad (3). With the arrangement, a voltage signal obtained at a predetermined point of the high frequency circuit can be measured.

## Description

### BACKGROUND OF THE INVENTION

### 1. Field of the Invention

The present invention relates to high frequency components having metal covers, communication apparatuses incorporating the high frequency components, and methods for measuring the characteristics of the high frequency components.

### 2. Description of the Related Art

In a conventional high frequency component such as a voltage-controlled oscillator or a PLL module used in a mobile phone or the like, various kinds of chip components are mounted on a substrate having an electrode pattern formed thereon. Additionally, a metal cover is attached over the substrate to cover the chip components formed on the substrate.

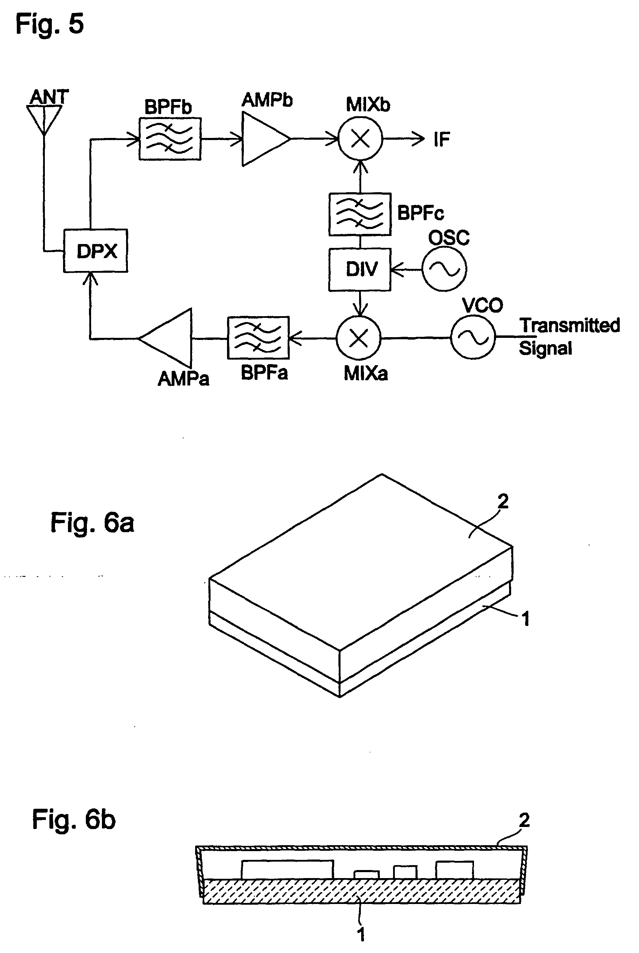

Each of Figs. 6A and 6B shows the structure of such a conventional high frequency component. In this case, Fig. 6A is a perspective view of the high frequency component, and Fig. 6B is a sectional view thereof. In both figures, the reference numeral 1 denotes a ceramic substrate. On an upper surface of the substrate 1 there are mounted various kinds of chip components. A metal cover 2 is attached over the substrate 1 such that the cover 2 covers the upper surface of the substrate 1, on which the components are mounted.

As shown above, in the conventional high frequency component, a high frequency circuit is formed on the substrate whose top portion is covered by the metal cover. When the characteristics of the high frequency circuit are measured regarding a signal other than the signal of an outwardly led-out terminal electrode, the measurement of a voltage is performed by allowing a probe of a measuring apparatus to contact an electrode pad on the substrate before covering the top of the substrate with the metal cover.

However, after measuring the characteristics of the component, when the metal cover is attached over the substrate to produce the high frequency component as a final product, a shielded space is created over the upper surface of the substrate by the metal cover. As a result, the characteristics of the high frequency component are changed due to the influence of a stray capacitance and electromagnetic coupling occurring between the metal cover and the components and the electrode pattern formed on the substrate. Thus, the obtained characteristics deviate from a predetermined characteristic range, and this is a factor by which the good product ratio, i.e., yield is deteriorated.

In order to prevent the problems, it is necessary to in advance obtain information about how the characteristics change before and after covering with the metal cover to predetermine the range of measured values necessary to obtain desirable characteristics. However, it is impossible to accurately predict how the characteristics change before and after covering with the metal cover. Thus, the good product ratio cannot be sufficiently increased.

### SUMMARY OF THE INVENTION

Accordingly, it is an object of the present invention to provide a method for easily measuring the characteristics of a high frequency circuit, which cannot be measured only by an outwardly led-out terminal electrode, at the final product stage. Additionally, it is another object of the invention to provide a communication apparatus incorporating a high frequency component having the predetermined characteristics.

According to the present invention, there is provided a high frequency component including a substrate, high frequency circuit components mounted on the substrate, a signal measuring electrode pad disposed on the substrate, a metal cover for covering the top of the substrate, and a hole provided in the metal cover, which is disposed in the vicinity of the signal measuring electrode pad.

In this arrangement, while the metal cover is attached over the substrate, the signal measuring electrode pad is arranged on the substrate such that the electrode pad can be in contact with a probe of a measuring apparatus inserted through the hole of the metal cover. In other words, a voltage signal in a predetermined position of the high frequency circuit can be measured at the final product stage.

In addition, in the high frequency component of the invention, the diameter or width of the hole may be made greater than the diameter or width of the signal measuring electrode pad and may be equal to or less than a length corresponding to 1/4 wavelength of a used frequency. This arrangement can sufficiently suppress the radiation or incidence of an electromagnetic wave of the used frequency band or a higher frequency band through the hole provided in the metal cover. As a result, the shielding effect of the metal cover can be maintained.

According to the present invention, there is provided a communication apparatus including the above high frequency component. In this communication apparatus, for example, the high frequency component is used as a high-frequency signal oscillator or a filter.

According to the present invention, there is provided a method for measuring the characteristics of the above high frequency component. In this method, the probe is inserted in the hole of the metal cover of the high frequency component to measure a voltage at the signal measuring electrode pad.

### BRIEF DESCRIPTION OF THE DRAWINGS

Figs. 1A and 1B are a perspective view and a sectional view of a high frequency component according to a first embodiment of the present invention;
Fig. 2 is a partial top view of the high frequency component;
Fig. 3 is a circuit diagram of the main part of the high frequency component;
Fig. 4 is a chart showing a method for measuring the characteristics of a high frequency component according to a second embodiment of the present invention;
Fig. 5 is a block diagram showing the structure of a communication apparatus according to a third embodiment of the present invention; and
Figs. 6A and 6B are a perspective view and a sectional view showing the structure of a conventional high frequency component.

### DESCRIPTION OF THE PREFERRED EMBODIMENTS

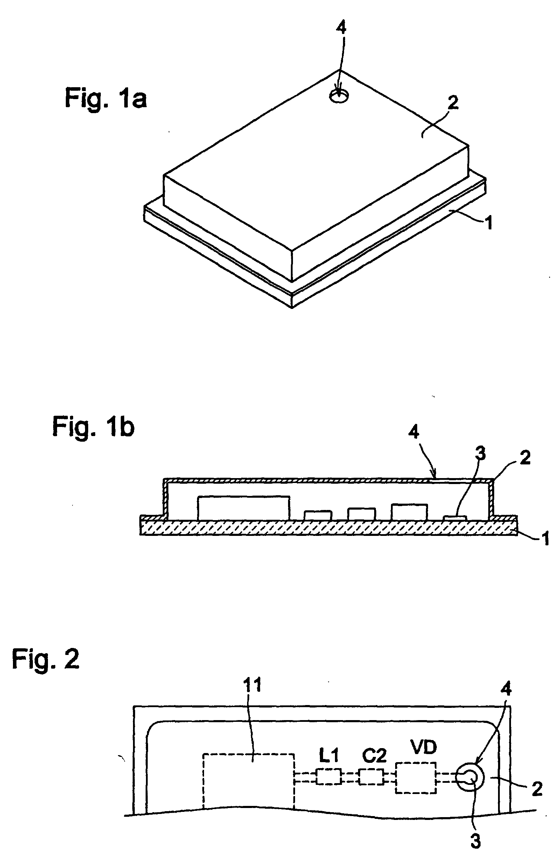

Figs. 1A and 1B to Fig. 3 illustrate the structure of a PLL module as a high frequency component according to a first embodiment of present invention.

Fig. 1A is a perspective view of the PLL module, and Fig. 1B is a sectional view thereof. In the PLL module, an electrode pattern is disposed on an upper surface of a ceramic substrate 1, and a plurality of chip components are mounted thereon. In a portion of a metal cover 2, a hole 4 is provided in the vicinity of a signal measuring electrode pad 3.

Fig. 2 is a partial top view of the PLL module. The inner diameter of the hole 4 is made greater than the diameter of the electrode pad 3 and is set to be equal to or less than a length corresponding to 1/4 wavelength of a used frequency. For example, when the diameter of the electrode pad 3 is 5 mm and the used frequency is 2.4 GHz, the diameter of the hole 4 is made less than a length of 31 mm corresponding to the 1/4 wavelength.

As shown above, the hole 4 is made greater than the electrode pad 3. With this arrangement, even if there is a slight positional deviation between the electrode pad 3 and the hole 4 of the metal cover 2, the probe of a measuring apparatus is not short-circuited to the metal cover. In addition, the position of the electrode pad 3 viewed through the hole 4 can be accurately recognized. As a result, the probe is allowed to appropriately abut with the center of the electrode pad 3.

In addition, the width of the hole 4 formed in the metal cover 2 is set to be equal to or less than a length corresponding to 1/4 wavelength of a used frequency. This arrangement can contribute to suppressing unnecessary radiation of an electromagnetic wave to the outside and incidence thereof from the outside to the inside of the high frequency component in the used frequency band or a higher frequency band. As a result, the shielding effect of the metal cover 2 can be maintained.

In this embodiment, although the hole 4 has a round shape, a rectangular hole may also be used. In the case of the rectangular hole, the vertical and horizontal widths of the hole need to be made greater than the dimension of the electrode pad 3 and need to be equal to or less than a length corresponding to 1/4 wavelength of a used frequency.

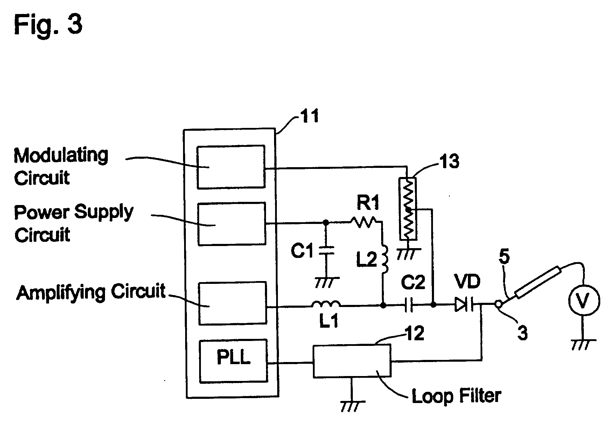

Fig. 3 is a circuit diagram of the main part of the PLL module. In this figure, the reference numeral 11 denotes a high frequency integrated circuit (IC). An amplifying circuit included in the high frequency IC 11 and a resonance circuit which is composed of a chip inductor L1, a chip capacitor C2, and a varactor diode VD constitute a voltage-controlled oscillation circuit (VCO). A loop-filter 12 is disposed at the output end of the PLL circuit of the high frequency IC 11. The output end of the loop filter 12 is connected to the cathode of the varactor diode VD. The output end of a modulating circuit included in the high frequency IC 11 is connected to the anode of the varactor diode VD via a resistance voltage divider circuit 13. Furthermore, a power supply circuit included in the high frequency IC 11 is connected to the chip inductor L1 via a capacitor C1, a resistor R1, and a choke coil L2. With this arrangement, a power supply voltage is applied to the amplifying circuit.

The PLL circuit performs a phase comparison between a reference frequency signal supplied from the outside and an oscillation signal sent from the oscillation circuit. Then, the PLL circuit transmits a phase error signal to the varactor diode VD via the loop filter 12 to change the electrostatic capacitance of the varactor diode VD so as to control the oscillation frequency. The modulating circuit controls a voltage applied to the varactor diode VD to modulate the oscillation frequency.

The reference numerals 11, L1, C2, and VD shown in Fig. 2 correspond to the high frequency IC 11, the chip inductor L1, the chip capacitor C2, and the varactor diode VD shown in Fig. 3. The electrode pad 3 shown in Figs. 1 to 3 is an electrode for measuring a cathode potential at the varactor diode VD, that is, a controlling voltage output from the PLL circuit via the loop filter 12. The controlling voltage is measured by allowing a probe 5 to abut with the electrode pad 3.

As shown above, by measuring the controlling voltage applied to the varactor diode from the PLL module, the relationship between the oscillation frequency and the controlling voltage can be measured at the finished product.

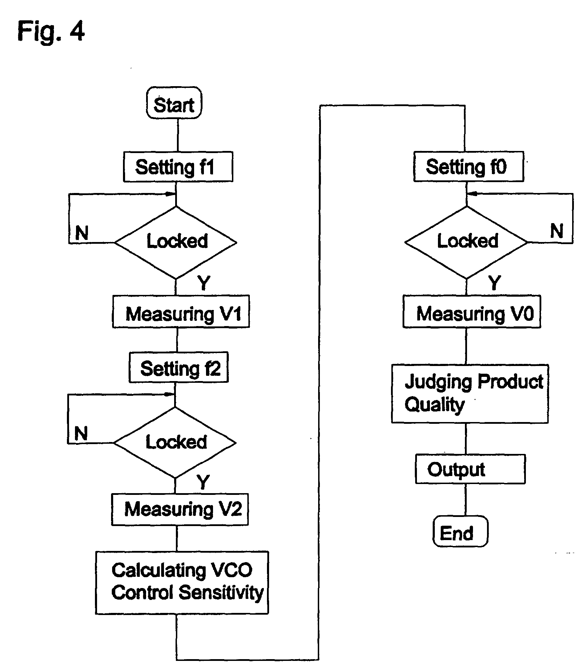

Next, as a second embodiment of the present invention, a method for measuring the characteristics of a PLL module will be explained with reference to a flowchart shown in Fig. 4.

The PLL module used in the second embodiment is a high frequency component shown in each of Figs. 1 to 3 (the PLL module). First, a controlling data is sent to the high frequency IC 11 such that the oscillation frequency of the PLL module shown in Fig. 3 is set at fl. The high frequency IC 11 determines a frequency division ratio with respect to a reference frequency signal based on the controlling data. When the PLL module is in a locked status, a voltage V1 at the point in time is measured by the probe 5. Sequentially, a controlling data is sent to the high frequency IC 11 to set the oscillation frequency at f2. Then, when the PLL module is in the locked status, a voltage V2 is measured by the probe 5. Next, a VCO control sensitivity is obtained as a value of (f2 - f1)/(V2 - V1). In addition, a controlling data is supplied to the high frequency IC 11 to set the oscillation frequency at a predetermined frequency fo within the range from f1 to f2, and a voltage Vo is measured when the PLL module is locked. After this, whether or not the VCO control sensitivity comes within a predetermined standard range and whether or not the voltage Vo comes within a predetermined standard range is judged, and the obtained results are output.

Measurement was actually performed by using the PLL module whose used frequency is 2.4 GHz band. For example, when fl was set at 2400 MHz, V1 was set at 0.7 V, and f2 was set at 2500 MHz, V2 was 1.7 V. As a result, the VCO control sensitivity was obtained by the equation (2500 - 2400)/(1.7 - 0.7) = 100 [MHz/V]. In the conventional PLL module at the final product stage, it was impossible to measure such a voltage and a VCO control sensitivity as shown above.

With the above arrangement, at the finished product, product quality, that is, whether the product is defective or not can be precisely determined.

Next, the structure of a communication apparatus according to a third embodiment of the present invention will be illustrated with reference to Fig. 5. In this figure, the reference character ANT denotes a transmission/reception antenna, the reference character DPX denotes a duplexer, and the reference characters BPFa, BPFb, and BPFc denote band pass filters. The reference characters AMPa and AMPb denote amplifying circuits, the reference characters MIXa and MIXb denote mixers. The reference character OSC denotes an oscillator, and the reference character DIV denotes a power divider. The reference character VCO denotes a voltage-controlled oscillator modulating an oscillation frequency with a signal corresponding to a transmitted signal (transmitted data).

The MIXa modulates a frequency signal output from the DIV with a modulation signal. The BPFa passes only signals of a transmitted frequency band and the AMPa performs power-amplification of the signals to transmit from the ANT via the DPX. The BPFb passes only signals of a received frequency band among the signals supplied from the DPX, and the AMPb amplifies the signals. The MIXb mixes a frequency signal output from the BPFc with the received signal to output an intermediate frequency signal IF.

The high frequency component shown in each of Figs. 1A and 1B to Fig. 4 is used as a high frequency component such as a VCO or a filter shown in Fig. 5, in which high frequency circuit components are mounted on a substrate and a metal cover is attached over the substrate. With this arrangement, there is provided a communication apparatus by using the high frequency component in which characteristics inside a high frequency circuit, which cannot be measured only by an outwardly exposed terminal electrode, fall within a predetermined range. Thus, after the assembly, the expected characteristics can be exhibited without fail.

Furthermore, in a state in which the high frequency component is disposed on the circuit substrate of the communication apparatus, through the hole of the metal cover, a voltage at a predetermined point inside the high frequency component can be measured. Thus, the above measurement may permit the determination of whether or not the high frequency component as a measured target acts with the predetermined characteristics when the communication apparatus as a final product is in operation.

In this manner, the communication apparatus incorporates the high frequency component having stable characteristics.

As described above, in the high frequency component and the communication apparatus including the same according to the present invention, while the metal cover is attached over the substrate, the signal measuring electrode pad on the substrate is allowed to be in contact with the probe of a measuring apparatus through the hole of the metal cover. As a result, at the finished product, a voltage signal in a predetermined position of the high frequency circuit can be measured.

In addition, radiation or incidence of electromagnetic waves of a used frequency band and a higher frequency band can be sufficiently suppressed through the hole formed in the metal cover. Thus, the shielding effect of the metal cover can be maintained.

According to the present invention, there is provided a high frequency circuit including, for example, a high-frequency signal oscillator, a filter, and the like, by using high frequency components having predetermined characteristics. As a result, a communication apparatus having predetermined communication capabilities can be easily obtained.

While the invention has particularly shown and described with reference to the preferred embodiments thereof, it will be understood by those skilled in the art that the foregoing and other changes in form and details can be made therein without departing from the spirit and scope of the invention.

## Claims

1. A high frequency component comprising:
a substrate (1);
high frequency circuit components (11, L1, C2, VD) mounted on the substrate (1);
a signal measuring electrode pad (3) disposed on the substrate (1);
a metal cover (2) for covering the top of the substrate (1); and
a hole (4) provided in the metal cover (2), which is disposed in the vicinity of the signal measuring electrode pad (3).

2. A high frequency component according to Claim 1, wherein the diameter or width of the hole (4) is made greater than the diameter or width of the signal measuring electrode pad (3) and are equal to or less than a length corresponding to 1/4 wavelength of a used frequency.

3. A communication apparatus comprising the high frequency component according to one of Claims 1 and 2.

4. A method for measuring the characteristics of a high frequency component comprising steps of:
inserting a probe (5) in the hole (4) of the metal cover (2) of the high frequency component according to one of Claims 1 and 2; and
measuring a voltage at the signal measuring electrode pad (3).
